## Europäisches Patentamt
## European Patent Office
## Office européen des brevets

(11) Numéro de publication : **0 076 195 B1**

(12)
# FASCICULE DE BREVET EUROPÉEN

(45) Date de publication du fascicule du brevet :
24.04.85

(21) Numéro de dépôt : 82401688.5

(22) Date de dépôt : 16.09.82

(51) Int. Cl.⁴ : **H 03 H 15/02, G 11 C 19/28**

(54) Dispositif de lecture en courant d'une quantité de charges électriques, et filtre à transfert de charges muni d'un tel dispositif.

(30) Priorité : 25.09.81 FR 8118135

(43) Date de publication de la demande :
06.04.83 Bulletin 83/14

(45) Mention de la délivrance du brevet :
24.04.85 Bulletin 85/17

(84) Etats contractants désignés :
DE GB NL

(56) Documents cités :
FR-A- 2 389 899
FR-A- 2 430 694
US-A- 3 623 132

(73) Titulaire : THOMSON-CSF
173, Boulevard Haussmann
F-75379 Paris Cedex 08 (FR)

(72) Inventeur : Benoit-Gonin, Roger
THOMSON-CSF SCPI 173, bld. Haussmann
F-75379 Paris Cedex 08 (FR)
Inventeur : Berger, Jean-Luc
THOMSON-CSF SCPI 173, bld. Haussmann
F-75379 Paris Cedex 08 (FR)
Inventeur : Coutures, Jean-Louis
THOMSON-CSF SCPI 173, Haussmann
F-75379 Paris Cedex 08 (FR)

(74) Mandataire : Ruellan, Brigitte et al
THOMSON-CSF SCPI 173, boulevard Haussmann
F-75379 Paris Cedex 08 (FR)

Jouve, 18, rue St-Denis, 75001 Paris, France

**Description**

La présente invention concerne un dispositif de lecture en courant d'une quantité de charges électriques. Elle concerne également les filtres à transfert de charges munis d'un tel dispositif.

De tels dispositifs sont connus, en particulier par la demande de brevet français, déposée le 4 juillet 1978 sous le n° 7 819 933, au nom de THOMSON-CSF et publiée sous le n° FR-A-2 430 694. Le dispositif selon la présente invention se distingue de celui décrit dans la demande de brevet citée par la structure du circuit de commande des transistors $Q_2$ et $Q_3$.

On rappelle que ce circuit de commande a pour rôle d'assurer la charge de la capacité $C_A$ et le maintien du transistor $Q_2$ en saturation, et par la suite le maintien d'un potentiel constant au point B d'arrivée des charges, lors de l'afflux des charges. Ainsi, cet afflux des charges a pour effet une variation de potentiel au point commun A des transistors $Q_2$ et $Q_3$, ce qui permet d'obtenir le signal de lecture.

Alors que dans la demande de brevet précédemment citée ce circuit de commande est constitué de trois transistors MOS $Q_4$, $Q_5$ et $Q_6$, et de deux capacités $C_E$ et $C_F$, dans le dispositif selon la présente invention, le circuit de commande ne comporte plus qu'un seul transistor et qu'une seule capacité.

Le dispositif selon la présente invention présente donc des avantages de simplicité et de diminution de l'encombrement.

La présente invention concerne un dispositif de lecture en courant d'une quantité de charges électriques comportant :

— un premier et un deuxième transistor MOS ($Q_2$ et $Q_3$) reliés en série au point d'arrivée (B) de la quantité de charges ;

— une première capacité ($C_A$), dont l'une des bornes est reliée au point commun (A) des deux transistors et dont l'autre borne est reliée à la masse du dispositif ;

— un circuit de commande de ces deux transistors assurant la charge de la première capacité ($C_A$) et le maintien du premier transistor ($Q_2$) en saturation, lors de l'afflux des charges, cet afflux ayant pour effet une variation de potentiel au point commun (A), qui fournit le signal de lecture, ce circuit de commande recevant un potentiel constant ($V_{DD}$) et comportant un troisième transistor MOS ($Q_4$) dont l'une des bornes est reliée au potentiel constant ($V_{DD}$) et dont l'autre borne est reliée au drain du deuxième transistor ($Q_3$) et une seconde capacité ($C_F$), reliée par l'une de ses bornes au point commun (F) du deuxième et du troisième transistor ($Q_3$ et $Q_4$), caractérisé en ce que :

— la grille du troisième transistor MOS ($Q_4$) est connectée directement au drain de ce troisième transitor qui est relié au potentiel constant ($V_{DD}$) ;

— la grille du deuxième transistor MOS ($Q_3$) est connectée directement au drain de ce deuxième transitor et à la source du troisième transistor MOS ($Q_4$) ;

— l'autre borne de la seconde capacité ($C_F$) est reliée à un signal d'horloge ($\phi_c$, $\phi_{RAZ}$, $\phi$, $\phi_l$) qui passe périodiquement d'un niveau bas à un niveau haut et vice-versa.

D'autres objets, caractéristiques et résultats de l'invention ressortiront de la description suivante, donnée à titre d'exemple non limitatif et illustrée par les figures annexées qui représentent :

les figures 1 et 2, des schémas du dispositif selon l'invention ;

les figures 3a, b et c, une vue en coupe transversale des transistors MOS $Q_3$ et $Q_4$ et des schémas expliquant leur fonctionnement.

Sur les différentes figures, les mêmes signes de référence désignent les mêmes éléments, mais, pour des raisons de clarté, les cotes et proportions des divers éléments ne sont pas respectés.

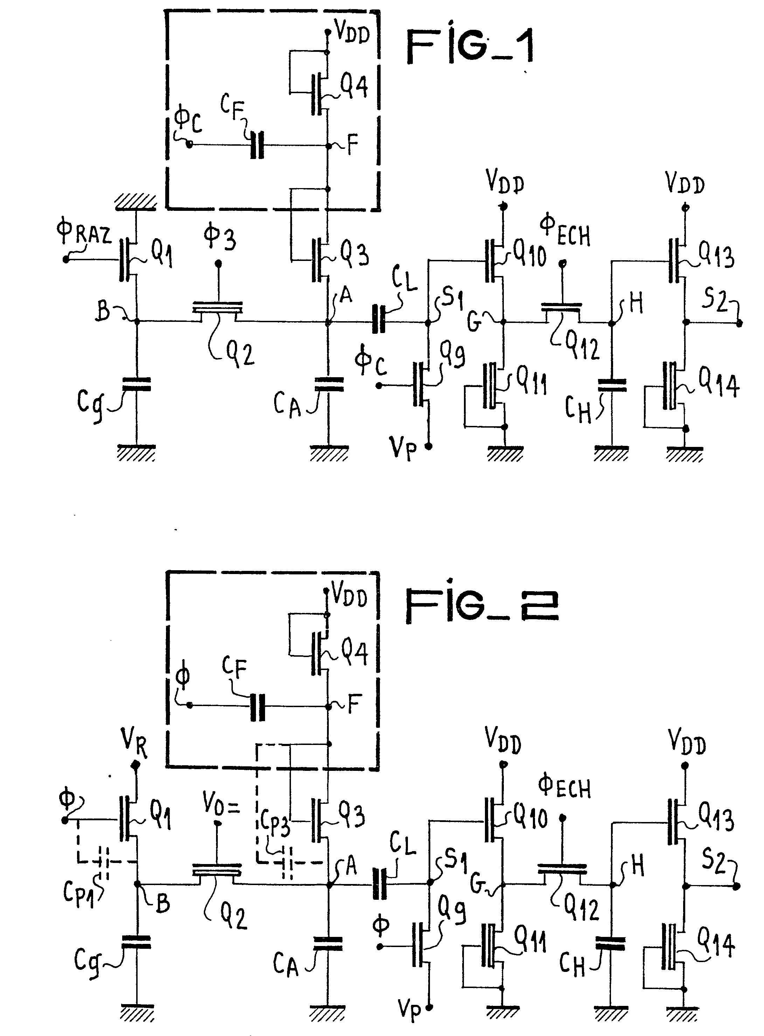

La figure 1 représente un schéma du dispositif de lecture en courant d'une quantité de charges électriques selon l'invention. Cette figure 1 ne diffère de la figure 1 de la demande de brevet précédemment citée que par la structure du circuit de commande des transistors MOS $Q_2$ et $Q_3$. Sur la figure 1, ce circuit de commande est entouré d'un cadre en trait discontinu. Sur les deux figures, on a utilisé les mêmes signes de référence. En ce qui concerne la description de la figure 1 de la présente demande de brevet, on se reportera donc à la description de la figure 1 de la demande de brevet précédemment citée, excepté en ce qui concerne le circuit de commande qui va être décrit.

On rappelle cependant que ce dispositif de lecture comporte deux transistors MOS $Q_2$ et $Q_3$ qui sont reliés en série au point d'arrivée B de la quantité de charges à lire.

Une capacité $C_A$ est reliée par l'une de ses bornes au point commun A des deux transistors. L'autre borne de la capacité $C_A$ est reliée à la masse. Le transistor MOS $Q_2$ reçoit la quantité de charges à mesurer par l'intermédiaire d'une capacité $C_g$, qui est connectée entre le point B et la masse. Au point B, est également connecté un transistor MOS $Q_l$ qui assure la remise à zéro du dispositif. Au point commun A du premier et du deuxième transistor est reliée une capacité $C_L$. Cette capacité est reliée par son autre borne $S_l$ à un transistor $Q_9$ qui permet à partir d'un second potentiel constant $V_P$, inférieur ou égal au potentiel $V_{DD}$ qui alimente le circuit de commande, une pré-charge de la capacité $C_L$. Enfin, le dispositif comporte un circuit assurant l'échantillonnage et maintien du signal disponible au point $S_l$, et fournissant le signal de sortie $S_2$ du dispositif.

Le circuit de commande selon la présente invention des transistors $Q_2$ et $Q_3$ est constitué par un transistor MOS à enrichissement $Q_4$, dont le drain et la grille sont reliés au potentiel constant $V_{DD}$. La source de $Q_4$ est reliée au drain et à la grille du transistor MOS $Q_3$. Une capacité $C_F$ est reliée par l'une de ses bornes au point commun F des transistors MOS $Q_3$ et $Q_4$. Sur son autre borne la capacité $C_F$ reçoit le signal d'horloge $\phi_C$ qui est représenté à la figure 2e, de la demande de brevet précédemment citée. Dans le circuit de commande selon la présente invention, le transistor MOS $Q_3$ est un transistor MOS à enrichissement ; dans la demande de brevet précédemment citée, le transistor MOS $Q_3$ était un transistor à déplétion. Le type des autres transistors MOS du dispositif (déplétion ou enrichissement) n'est pas modifié.

La présente description est faite dans le cas de transistors MOS à canal N dont la plupart sont à enrichissement et dont certains — $Q_2$, $Q_{11}$ et $Q_{14}$ — sont à déplétion. Il est bien entendu qu'il est possible de réaliser le dispositif avec des transistors MOS à canal P. De même, il est possible de remplacer certains transistors MOS à déplétion par des transistors MOS à enrichissement, et vice-versa. Toutefois, les transistors $Q_3$ et $Q_4$ sont des transistors à enrichissement et si l'on utilise pour $Q_{11}$ et $Q_{14}$ des transistors MOS à enrichissement, on doit connecter leur grille à leur drain au lieu de la connecter à leur source, comme c'est le cas sur la figure 1. On peut aussi remarquer qu'en ce qui concerne le transistor MOS $Q_2$, on a intérêt à conserver un transistor MOS à déplétion dont le bruit propre est moins élevé que celui d'un transitor MOS à enrichissement.

On va maintenant examiner le fonctionnement de circuit de commande des transistors MOS $Q_2$ et $Q_3$ selon la présente invention.

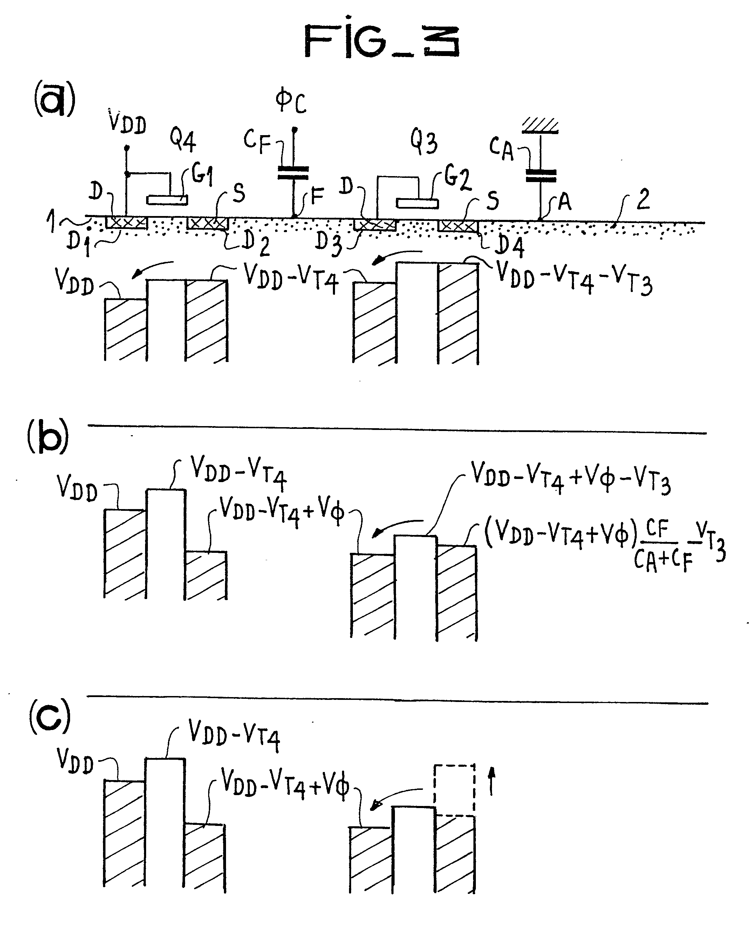

Pour expliquer ce fonctionnement, on va utiliser les figures 3a, b et c qui montrent une vue en coupe transversale des transistors MOS $Q_3$ et $Q_4$ et des schémas qui représentent l'évolution du potentiel de surface $\phi_S$ dont le substrat semi-conducteur 2. Les zones hachurées indiquent la présence de porteurs minoritaires. Sur la figure 3a, on trouve de gauche à droite :

— le transistor MOS $Q_4$ constitué par deux diodes $D_1$ et $D_2$ et par une grille $G_1$. La diode $D_1$ et la grille $G_1$ sont reliées au potentiel constant $V_{DD}$ ;

— la capacité $C_F$ qui reçoit le signal d'horloge $\phi_C$ et qui est connectée au point F. Cette capacité n'est généralement pas intégrée sur la pastille de semi-conducteur à cause de sa valeur élevée ;

— le transistor MOS $Q_3$ qui est constitué par deux diodes $D_3$ et $D_4$ et par une grille $G_2$. La diode $D_3$ et la grille $G_2$ sont réunies ;

— la capacité $C_A$ qui est généralement intégrée sur la pastille de semi-conducteur 2, et qui est représentée de façon symbolique sur la figure 3a, connectée entre le point A et la masse.

La figure 3a représente l'évolution des potentiels de surface, en régime initial, c'est-à-dire lorsque le signal d'horloge $\phi_C$ se trouve encore au niveau bas et n'a jamais été au niveau haut.

Etant donnée la façon dont les transistors $Q_3$ et $Q_4$ sont connectés, ils se trouvent en régime de saturation.

Le potentiel sur la diode $D_1$ est fixé à $V_{DD}$. Sous la grille $G_1$, le potentiel est fixé à $V_{DD} - V_{T4}$, où $V_{T4}$ représente la tension de seuil du transistor $Q_4$. La diode $D_2$ et la diode $D_3$ s'alignent sur le potentiel $V_{DD} - V_{T4}$. Sous la grille $G_2$ du transistor $Q_3$, on trouve donc un potentiel égal à $V_{DD} - V_{T4} - V_{T3}$, où $V_{T3}$ représente la tension de seuil du transistor $Q_3$. La diode $D_4$ du transistor $Q_3$ s'alignent également sur ce potentiel.

La capacité $C_F$ connectée au point F se charge à travers le transistor $Q_4$, sensiblement à courant constant, au potentiel : $V_{DD} - V_{T4}$. Pendant le même temps, la capacité $C_A$ se charge à travers le transistor MOS $Q_3$, sensiblement à courant constant, au potentiel : $V_{DD} - V_{T4} - V_{T3}$.

La figure 3b, représente l'évolution des potentiels de surface lorsque le signal d'horloge $\phi_C$ passe au niveau haut. Les signaux d'horloge du dispositif lorsqu'ils passent du niveau bas au niveau haut, passent d'une tension de zéro volt à une tension égale à $V_\phi$. Lorsque le signal de commande $\phi_C$ passe au niveau haut, le potentiel sur les diodes $D_2$ et $D_3$ passe à : $V_{DD} - V_{T4} + V_\phi$. Le transistor MOS $Q_4$ se trouve donc bloqué. Sous la grille $G_2$ et la diode $D_4$, le potentiel s'établit à : $V_{DD} - V_{T4} + V_\phi - V_{T3}$. La capacité $C_A$ se charge à travers le transistor $Q_3$ qui est toujours en saturation à un potentiel qui s'écrit :

$$(V_{DD} - V_{T4} + V_\phi) \cdot \frac{C_F}{C_A + C_F} - V_{T3} \, .$$

Sur la diode $D_4$ connectée au point A, on retrouve ce même potentiel.

Cette tension est la tension de pré-charge du point A qui permet de mettre le transistor $Q_2$ en saturation avant que les charges n'arrivent au point B au temps $t_3$ qui est représenté sur la figure 2a du document cité comme l'instant où le signal d'horloge $\phi_1$, qui est appliqué au filtre à transfert de charge sur lequel on veut lire des charges, revient à zéro.

La capacité $C_F$ peut recevoir le signal d'horloge $\phi_C$ comme cela a été représenté sur la figure 1. On peut aussi utiliser le signal d'horloge $\phi_{RAZ}$, qui est représenté sur la figure 2c de la demande de brevet précédemment citée. On peut aussi utiliser tout autre signal d'horloge qui soit au niveau haut pendant le temps $T_0$ indiqué sur la figure 2a de la demande de brevet précédemment citée.

La figure 3c représente l'évolution des potentiels de surface dans le substrat lorsque le signal d'horloge $\phi_C$ passe au niveau bas. Au temps $t_3$, une quantité de charges $Q_s$ arrive au point B ce qui se traduit par une diminution du potentiel en B. Cette quantité de charges $Q_s$ est transmise au point A et la capacité $C_A$ se décharge d'une quantité de charges égale à la quantité de charges $Q_s$. Le potentiel en A

3

est diminué. Le potentiel sur la diode $D_4$ diminue puis s'aligne sur celui existant sous la grille $G_2$.

La valeur de la capacité $C_F$ est choisie suffisamment importante pour que cette capacité ne se décharge pratiquement pas lorsque le signal d'horloge $\phi_C$ se trouve au niveau bas.

Lorsque le signal d'horloge $\phi_C$ passe à nouveau au niveau haut, les charges des capacités $C_A$ et $C_F$ sont à nouveau fixées de façon bien précise. On retrouve les potentiels de la figure 3b.

En pratique, la capacité $C_F$ a une valeur trente à cent fois supérieure à celle de la capacité $C_A$. Des valeurs typiques des tensions $V_{DD}$, $V_\phi$, $V_{T3}$ et $V_{T4}$ sont :

$$V_{DD} = 12V$$
$$V_\phi = 17V$$
$$V_{T3} = V_{T4} = 3V$$

Si on choisit $C_F/C_A = 100$, la tension de pré-charge du point A, $V_A$, qui est calculée égale 22,7V. En fait, la tension $V_A$ mesurée n'est que de 18V à cause des capacités parasites du circuit.

On constate que la tension de pré-charge du point A, $V_A$, est de l'ordre de vingt volts alors que le dispositif ne réclame pour fonctionner qu'une tension continue ne dépassant pas $V_{DD}$, qui est de l'ordre de douze volts.

La valeur de la capacité $C_F$ dépend de la valeur de la capacité $C_A$. Si on choisit de prendre pour valeur de $C_A$ : $C_A = 10pF$, la capacité $C_F$ est alors une capacité de 300 à 1 000pF qui sera extérieure au substrat. En général, la capacité $C_A$ sera intégrée sur la pastille de semi-conducteur. En pratique, il est possible d'intégrer des capacités jusqu'à 30pF sans que cela pose de problèmes, d'encombrement notamment.

La figure 2 représente un schéma du dispositif selon l'invention qui présente quelques modifications par rapport au schéma de la figure 1.

On remarque que le transistor $Q_2$ reçoit sur sa grille une tension continue $V_O$, les transistors $Q_1$ et $Q_9$ et la capacité $C_F$ reçoivent le même signal d'horloge $\phi$. De plus on a représenté sur la figure 2 les capacités parasites $C_{P1}$ et $C_{P3}$ existant sur les transistors $Q_1$ et $Q_3$.

Pour simplifier les circuits d'horloge et faciliter l'obtention des signaux d'horloge dans le cas de fonctionnement à plus haute fréquence, le filtre à transfert de charge sur lequel le dispositif selon l'invention permet d'effectuer des lectures de quantité de charges peut fonctionner en monophase, c'est-à-dire avec un seul signal d'horloge.

Les filtres à transfert de charges sont décrits dans la demande de brevet précédemment citée.

On rappelle que les filtres à transfert de charges associés aux dispositifs de lecture selon l'invention, comportent un substrat semi-conducteur recouvert d'une couche isolante sur laquelle sont déposées des électrodes de stockage des charges. Des électrodes de transfert des charges sont déposées entre les électrodes de stockage dont elles sont isolées par une couche isolante supplémentaire. Chaque électrode de transfert est reliée à l'électrode de stockage adjacente. Une électrode de stockage sur deux est coupée en deux ou plusieurs parties et la lecture ne s'effectue généralement que sous une partie de chaque électrode de stockage coupée.

Lorsqu'il fonctionne en monophasé, le filtre ne reçoit pas les signaux d'horloge $\phi_1$ et $\phi_2$ qui sont représentés sur les figures 2a et 2b de la demande de brevet précédemment citée.

Ce filtre ne reçoit plus alors qu'un seul signal d'horloge, $\phi_1$, par exemple, qui est appliqué par exemple, aux électrodes de stockage impaires.

Les électrodes de stockage paires reçoivent alors une tension continue proche de $V_\phi/2$ et la lecture se fait sous ces électrodes.

La grille de $Q_2$ recevant la tension $V_0$ proche de $V_\phi/2$, lorsque la quantité de charges à lire $Q_s$ arrive au point B, le transistor $Q_2$ est alors en saturation et la tension au point B égale : $V_0 - V_{T2}$. Les électrodes de stockage paires sous lesquelles se fait la lecture sont généralement coupées en deux ou plusieurs parties. La lecture des charges ne s'effectue généralement que sous une partie de chacune de ces électrodes de stockage. Les parties non utiles des électrodes de stockage sont reliées à la tension continue $V_\phi/2$, il est alors préférable d'appliquer lors de la lecture la même tension sous les parties utiles des électrodes de stockage qui sont reliées au point B.

On choisit donc en conséquence le potentiel $V_0$ tel que :

$$V_O - V_{T2} = V_\phi/2 \,, \qquad \text{soit} \qquad V_O = V_\phi/2 + V_{T2} \,.$$

Dans le cas de la figure 1, la capacité $C_F$ et le transistor $Q_9$ reçoivent le signal d'horloge $\phi_C$, et le transistor $Q_1$ reçoit le signal d'horloge $\phi_{RAZ}$. On peut appliquer à la capacité $C_F$ et aux transistors $Q_1$ et $Q_9$ le même signal d'horloge $\phi$. Ce signal d'horloge peut être l'un des signaux $\phi_C$ ou $\phi_{RAZ}$, ou bien un signal intermédiaire qui soit au niveau haut pendant le temps $T_2$ qui est indiqué sur la figure 2 de la demande de brevet précédemment citée. Dans le cas de la figure 2 où le filtre auquel le dispositif de lecture est associé fonctionne en monophasé, on peut utiliser comme signal d'horloge $\phi$ le signal d'horloge $\phi_1$.

Il faut alors s'assurer que le transistor $Q_1$ passe bien à l'état bloqué avant que la quantité de charges à lire n'arrive au point B.

On remarque en effet que sur la figure 2 le transistor $Q_1$ n'est plus connecté à la masse mais à une tension continue réglable $V_R$. Etant donnée la tension de seuil du transistor $Q_1$ et la tension de polarisation $V_R$ qui est habituellement choisie, le transistor $Q_1$ se trouve bloqué lorsque $\phi_1$ arrive à $V_\phi/2$, alors que les charges n'ont pas encore été transférées sous les électrodes de stockage reliées au point B.

Lorsque le signal d'horloge $\phi_1$ est appliqué à la capacité $C_F$ et aux transistors $Q_1$ et $Q_9$, deux signaux d'horloge $\phi_1$ et $\phi_{ECH}$ suffisent à assurer le fonctionnement en monophasé du filtre et de son dispositif de lecture.

Les couplages parasites jouent un rôle important pour fixer les potentiels aux points A et B au moment de la lecture. Sur la figure 2 on a représenté de façon symbolique, en pointillés, les capacités parasites $C_{P3}$ entre l'ensemble drain plus grille et la source de $Q_3$, et $C_{P1}$ entre la grille et le drain de $Q_1$. Il faut aussi tenir compte de la capacité de recouvrement $C_r$ entre les électrodes de transfert et de stockage du filtre auquel le dispositif de lecture est relié. A cause de ces capacités parasites, la variation totale des potentiels au point A lors de l'arrivée en B d'une quantité de charges $Q_S$ s'écrit :

$$\frac{Q_S}{C_A} + \frac{C_{p3}}{C_A} \cdot V_\phi + \frac{C_{p1} + C_r}{C_A} \cdot V_\phi - [V_R - (V_O + V_{T2})] \cdot \frac{C_g}{C_A}.$$

Le dernier terme montre qu'il est possible en ajustant la tension continue réglable $V_R$ de corriger l'erreur introduite par les capacités parasites $C_{P1}$, $C_{P3}$ et $C_r$.

Il est bien entendu qu'il est possible d'associer le dispositif seon l'invention à des filtres à transfert de charges de structure légèrement différente, pour lesquels en particulier, la lecture des charges s'effectue sous deux parties de chaque électrode de stockage coupée.

## Revendications

1. Dispositif de lecture en courant d'une quantité de charges électriques comportant :
— un premier et un deuxième transistors MOS ($Q_2$ et $Q_3$) reliés en série au point d'arrivée (B) de la quantité de charges ;
— une première capacité ($C_A$), dont l'une des bornes est reliée au point commun (A) des deux transistors et dont l'autre borne est reliée à la masse du dispositif ;
— un circuit de commande de ces deux transitors assurant la charge de la première capacité ($C_A$) et le maintien du premier transistor ($Q_2$) en saturation, lors de l'afflux des charges, cet afflux ayant pour effet une variation de potentiel au point commun (A), qui fournit le signal de lecture, ce circuit de commande recevant un potentiel constant ($V_{DD}$) et comportant un troisième transistor MOS ($Q_4$) dont l'une des bornes est reliée au potentiel constant ($V_{DD}$) et dont l'autre borne est reliée au drain du deuxième transistor ($Q_3$) et une seconde capacité ($C_F$), reliée par l'une de ses bornes au point commun (F) du deuxième et du troisième transistors ($Q_3$ et $Q_4$), caractérisé en ce que :
— la grille du troisième transistor MOS ($Q_4$) est connectée directement au drain de ce troisième transistor qui est relié au potentiel constant ($V_{DD}$) ;
— la grille du deuxième transistor MOS ($Q_3$) est connectée directement au drain de ce deuxième transistor et à la source du troisième transistor ($Q_4$).
— l'autre borne de la seconde capacité ($C_F$) est reliée à un signal d'horloge ($\phi_c$, $\phi_{RAZ}$, $\phi$, $\phi_1$) qui passe périodiquement d'un niveau bas à un niveau haut et vice-versa.

2. Dispositif selon la revendication 1, caractérisé en ce qu'au point d'arrivée (B) est connectée une troisième capacité ($C_g$) de stockage des charges.

3. Dispositif selon l'une des revendications 1 ou 2, caractérisé en ce qu'il comporte un quatrième transistor ($Q_1$) assurant la remise à zéro du dispositif.

4. Dispositif selon l'une des revendications 1 à 3, caractérisé en ce qu'il comporte une quatrième capacité ($C_L$) reliée au point commun (A) des premier et deuxième transistors ($Q_2$, $Q_3$), qui est reliée par son autre borne ($S_1$) à un cinquième transistor ($Q_9$) qui permet, à partir d'un second potentiel constant ($V_P$) inférieur ou égal au premier ($V_{DD}$), une pré-charge de la quatrième capacité ($C_L$).

5. Dispositif selon la revendication 4, caractérisé en ce qu'il comporte un circuit assurant l'échantillonnage et maintien du signal disponible au point commun ($S_1$) de la quatrième capacité ($C_L$) et du cinquième transistor ($Q_9$), et fournissant le signal de sortie du dispositif.

6. Dispositif selon l'une des revendications précédentes, caractérisé en ce que le deuxième et le troisième transistors ($Q_3$ et $Q_4$) sont des transistors à enrichissement.

7. Dispositif selon l'une des revendications précédentes, caractérisé en ce que le premier transistor ($Q_2$) est un transistor à déplétion.

8. Dispositif selon l'une des revendications précédentes, caractérisé en ce que le quatrième transistor ($Q_1$) et le cinquième transistor ($Q_9$) sont des transistors à enrichissement.

9. Dispositif selon l'une des revendications précédentes, caractérisé en ce que les transistors MOS sont à canal N.

10. Filtre à transfert de charges, comportant un substrat semi-conducteur recouvert d'une couche

**0 076 195**

isolante, sur laquelle alternent des électrodes de transfert et des électrodes de stockage des charges, ces électrodes assurant, sur application de potentiels donnés, le transfert des charges dans le substrat, caractérisé en ce qu'il comporte un dispositif selon l'une des revendications précédentes qui assure la lecture de quantités de charges sous les électrodes de stockage coupées en deux ou plusieurs parties.

11. Filtre selon la revendication 10, caractérisé en ce qu'il fonctionne en monophasé, une électrode de stockage sur deux recevant un signal d'horloge ($\phi_1$) alors que les autres électrodes de stockage sont coupées en deux ou plusieurs parties, la lecture des charges s'effectuant sous au moins une partie de chacune de ces électrodes de stockage, dont les parties non utiles reçoivent une tension constante ($V_d/2$), et en ce que le premier transistor ($Q_2$) reçoit sur sa grille une tension constante ($V_d/2 + V_{T2}$), où $V_{T2}$ représente la tension de seuil du premier transistor ($Q_2$), et telle que le potentiel du point B auquel sont reliées les parties utiles des électrodes de stockage, égale lors de l'afflux des charges, celui ($V_d/2$) appliqué sur les parties non utiles des électrodes de stockage.

12. Filtre selon l'une des revendications 10 ou 11, caractérisé en ce que la seconde capacité ($C_F$), et le quatrième ($Q_1$) et le cinquième ($Q_9$), transistors reçoivent le même signal d'horloge ($\phi$).

13. Filtre selon les revendications 11 et 12, caractérisé en ce que ce signal d'horloge ($\phi$) est le même que celui qui est appliqué à une électrode de stockage sur deux.

14. Filtre selon l'une des revendications 10 à 13, caractérisé en ce que l'une des bornes du quatrième transistor ($Q_1$) reçoit une tension continue ($V_R$) qui est ajustée pour compenser les charges parasites transférées au point commun (A) du premier et du deuxième transistors ($Q_2$ et $Q_3$) en même temps que la quantité de charges à lire.

**Claims**

1. A device for current-reading of a quantity of electric charges, comprising

— a first and a second MOS-transistor ($Q_2$ and $Q_3$) connected in series to the point of arrival (B) of the quantity of charges,

— a first capacitor ($C_A$) connected through one of its terminals to the common point (A) of the two capacitors and through its other terminal to the ground potential of the device,

— a control circuit for said two transistors, the function of said circuit being to charge the first capacitor ($C_A$) and to maintain the first transistor ($Q_2$) in the saturated state during the inflow of the charges, the effect of said inflow being to produce a variation in potential at the common point (A) which delivers the reading signal, said control circuit receiving a constant potential ($V_{DD}$) and comprising a third MOS-transistor ($Q_4$), one terminal of which is connected to the constant potential ($V_{DD}$), and the second terminal of which is connected to the drain of the second transistor ($Q_3$), and comprising a second capacitor ($C_F$), one terminal of which is connected to the common point (F) of the second and third transistors ($Q_3$ and $Q_4$), characterized in that

— the gate of the third MOS-transistor ($Q_4$) is directly connected to the drain of said third transistor which is connected to the constant potential ($V_{DD}$),

— the gate of the second MOS-transistor ($Q_3$) is directly connected to the drain of said second transistor and to the source of the third transistor ($Q_4$),

— whereas the other terminal of the second capacitor ($C_F$) is connected to a clock signal ($\phi_c$, $\phi_{RAZ}$, $\phi$, $\phi_1$), this signal changing periodically between a low level and a high level.

2. A device according to claim 1, characterized in that a third capacitor ($C_g$) for storing the charges is connected to the point of arrival (B).

3. A device according to one of the claims 1 or 2, characterized in that it comprises a fourth transistor ($Q_1$) which ensures the resetting of the device to zero.

4. A device according to one of the claims 1 to 3, characterized in that it comprises a fourth capacitor ($C_L$) connected to the common point (A) of the first and second transistors ($Q_2$, $Q_3$) and connected through its other terminal ($S_1$) to a fifth transistor ($Q_9$), the function of which is to recharge the fourth capacitor ($C_L$) on the basis of a second constant potential ($V_p$) which is lower than or equal to the first constant potential ($V_{DD}$).

5. A device according to claim 4, characterized in that it comprises a circuit for sampling and holding the signal which is presented by the common point ($S_1$) of the fourth capacitor ($C_L$) and of the fifth transistor ($Q_9$), this circuit delivering the output signal of the device.

6. A device according to one of the preceding claims, characterized in that the second and third transistors ($Q_3$ and $Q_4$) are transistors of the enrichment type.

7. A device according to one of the preceding claims, characterized in that the first transistor ($Q_2$) is of the depletion type.

8. A device according to one of the preceding claims, characterized in that the fourth transistor ($Q_1$) and the fifth transistor ($Q_9$) are of the enrichment type.

9. A device according to one of the preceding claims, characterized in that the MOS-transistors are of the channel N type.

10. A charge transfer filter comprising a semiconductor substrate which is covered by an insulating layer and on which transfer electrodes and charge storage electrodes alternate, these electrodes ensuring the transfer of the charges of the substrate when given potentials are applied, characterized in that it comprises a device according to one of the preceding claims which ensures the reading of quantities of charges beneath the storage electrodes which are split into two or more parts.

11. A filter according to claim 10, characterized in that it operates in the monophase mode, one storage electrode out of two receiving a clock signal ($\phi_1$), whereas the other storage electrodes are cut into two or more parts, reading of the charges being carried out beneath at least one part of each of said storage electrodes in which the non-useful parts receive a constant voltage ($V_\phi/2$), and that the first transistor ($Q_2$) receives on its gate a constant voltage ($V_\phi/2 + V_{T2}$) where $V_{T2}$ represents the threshold voltage of the first transistor ($Q_2$), in such a way, that the potential at the point B, to which the useful parts of the storage electrodes are connected, becomes equal to the constant potential ($V_\phi/2$) applied to the non-useful parts of the storage electrodes during the inflow of the charges.

12. A filter according to one of the claims 10 or 11, characterized in that the second capacitor ($C_F$) and the fourth and fifth transistors ($Q_1$ and $Q_9$) receive the same clock signal ($_\phi$).

13. A filter according to the claims 11 and 12, characterized in that the clock signal ($_\phi$) is the same as that which is applied to one storage electrode out of two.

14. A filter according to one of the claims 10 to 13, characterized in that one of the terminals of the fourth transistor ($Q_1$) receives a DC voltage ($V_R$) which is adjusted so as to compensate for the parasitic charges transferred to the common point (A) of the first and the second transistors ($Q_2$ and $Q_3$) at the same time as the quantity of charges to be read.

**Patentansprüche**

1. Lesevorrichtung für eine elektrische Ladungsmenge in Form eines Stroms, mit
— einem ersten und einem zweiten MOS-Transistor ($Q_2$ und $Q_3$), die in Reihe an den Eingangspunkt (B) angeschlossen sind, an dem die Ladungsmenge ankommt ;
— einem ersten Kondensator ($C_A$), dessen einer Anschluß an den gemeinsamen Punkt (A) der beiden Transistoren und dessen anderer Anschluß an den Massepol der Vorrichtung angeschlossen sind ;
— einem Steuerkreis für diese beiden Transistoren, mit dem das Aufladen des ersten Kondensators ($C_A$) und das Halten des ersten Transistors ($Q_2$) in der Sättigung während der Zufuhr dieser Ladungen sichergestellt wird, wobei diese Zufuhr zu einer Änderung des Potentials am gemeinsamen Punkt (A), an dem das Lesesignal abgreifbar ist, führt, und wobei der Steuerkreis ein konstantes Potential ($V_{DD}$) zugeführt erhält und einen dritten MOS-Transistor ($Q_4$), von dem ein Anschluß an dem konstanten Potential ($V_{DD}$) liegt und der andere mit dem Drain des zweiten Transistors ($Q_3$) verbunden ist, und einen zweiten Kondensator ($C_F$) enthält, dessen einer Anschluß am gemeinsamen Punkt (F) des zweiten und dritten Transistors ($Q_3$ und $Q_4$) liegt, dadurch gekennzeichnet, daß
— das Gate des dritten MOS-Transistors ($Q_4$) direkt mit dem Drain dieses dritten Transistors verbunden ist, der am konstanten Potential ($V_{DD}$) liegt ;
— das Gate des zweiten MOS-Transistors ($Q_3$) direkt am Drain dieses zweiten Transistors und an der Quelle des dritten Transistors ($Q_4$) liegt ;
— der zweite Anschluß des zweiten Kondensators ($C_F$) mit einem Taktsignal ($\phi_c$, $\phi_{RAZ}$, $\phi$, $\phi_1$) verbunden ist, das periodisch von einem niedrigen auf einen hohen Pegel übergeht und umgekehrt.

2. Vorrichtung nach Anspruch 1, dadurch gekennzeichnet, daß am Eingangspunkt (B) ein dritter Kondensator ($C_9$) für die Speicherung der Ladungen angeschlossen ist.

3. Vorrichtung nach einem der Ansprüche 1 oder 2, dadurch gekennzeichnet, daß sie einen vierten Transistor ($Q_1$) enthält, mit dem die Vorrichtung auf Null gesetzt wird.

4. Vorrichtung nach einem der Ansprüche 1 bis 3, dadurch gekennzeichnet, daß sie einen vierten Kondensator ($C_L$) enthält, der an den Verbindungspunkt (A) des ersten und zweiten Transistors ($Q_2$, $Q_3$) angeschlossen ist, während sein anderer Anschluß ($S_1$) mit einem fünften Transistor ($Q_9$) verbunden ist, der ausgehend von einem zweiten konstanten Potential ($V_p$), das höchstens gleich dem ersten konstanten Potential ($V_{DD}$) ist, ein Vorladen des vierten Kondensators ($C_L$) erlaubt.

5. Vorrichtung nach Anspruch 4, dadurch gekennzeichnet, daß sie einen Schaltkreis aufweist, der das Abtasten und Halten des am gemeinsamen Punkt ($S_1$) des vierten Kondensators ($C_L$) und des fünften Transistors ($Q_9$) verfügbaren Signals bewirkt und das Ausgangssignal der Vorrichtung liefert.

6. Vorrichtung nach einem der vorhergehenden Ansprüche, dadurch gekennzeichnet, daß der zweite und der dritte Transistor ($Q_3$ und $Q_4$) Transistoren vom Anreicherungstyp sind.

7. Vorrichtung nach einem der vorhergehenden Ansprüche, dadurch gekennzeichnet, daß der erste Transistor ($Q_2$) ein Transistor vom Verarmungstyp ist.

8. Vorrichtung nach einem der vorhergehenden Ansprüche, dadurch gekennzeichnet, daß der vierte Transistor ($Q_1$) und der fünfte Transistor ($Q_9$) Transistoren vom Anreicherungstyp sind.

9. Vorrichtung nach einem der vorhergehenden Ansprüche, dadurch gekennzeichnet, daß die MOS-Transistoren vom N-Kanal-Typ sind.

10. Ladungstransferfilter, das ein mit einer Isolierschicht bedecktes Halbleitersubstrat enthält, auf dem Transferelektroden und Speicherelektroden für die Ladungen einander abwechseln, wobei diese Elektroden aufgrund gegebener angelegter Potentiale den Transfer der Ladungen auf dem Substrat bewirken, dadurch gekennzeichnet, daß es eine Vorrichtung gemäß einem der vorhergehenden Ansprüche aufweist, die die Erfassung der Ladungsmengen unter den Speicherelektroden, die in zwei oder mehr Teile zerschnitten sind, bewirkt.

11. Filter nach Anspruch 10, dadurch gekennzeichnet, daß es in Monophase betrieben wird, wobei jede zweite Speicherelektrode ein Taktsignal ($\phi_1$) empfängt, während die anderen Speicherelektroden in zwei oder mehr Teile zerschnitten sind, wobei die Erfassung der Ladungen unter mindestens einem Teil jeder dieser Speicherelektroden erfolgt und die nicht-nützlichen Teile eine konstante Spannung ($V_d/2$) zugeführt erhalten, und daß der erste Transistor ($Q_2$) über sein Gate eine konstante Spannung ($V_d/2 + V_{T2}$) zugeführt erhält, bei der $V_{T2}$ die Schwellenspannung des ersten Transistors ($Q_2$) bildet, derart, daß das Potential am Punkt B, an den die Nutzteile der Speicherelektroden angeschlossen sind, während der Ladungszufuhr dem Potential ($V_d/2$) gleicht, das an die nicht-nützlichen Teile der Speicherelektroden angelegt ist.

12. Filter nach einem der Ansprüche 10 oder 11, dadurch gekennzeichnet, daß der zweite Kondensator ($C_F$) und der vierte und fünfte Transistor ($Q_1$ und $Q_9$) dasselbe Taktsignal ($\phi$) zugeführt erhalten.

13. Filter nach den Ansprüchen 11 und 12, dadurch gekennzeichnet, daß das Taktsignal ($\phi$) dasselbe ist wie das Taktsignal, das an jede zweite Speicherelektrode angelegt ist.

14. Filter nach einem der Ansprüche 10 bis 13, dadurch gekennzeichnet, daß einer der Anschlüsse des vierten Transistors ($Q_1$) eine Gleichspannung ($V_R$) zugeführt erhält, die so festgelegt ist, daß die an den gemeinsamen Punkt (A) des ersten und zweiten Transistors ($Q_3$ und $Q_4$) gleichzeitig mit den zu erfassenden Ladungsmengen übertragenen parasitären Ladungen kompensiert werden.

0 076 195

FIG_1

FIG_2

# FIG_3

**(a)**

**(b)**

$V_{DD}$

$V_{DD}-V_{T4}$

$V_{DD}-V_{T4}+V\phi$

$V_{DD}-V_{T4}+V\phi-V_{T3}$

$$\left(V_{DD}-V_{T4}+V\phi\right)\frac{C_F}{C_A+C_F}-V_{T3}$$

**(c)**

$V_{DD}$

$V_{DD}-V_{T4}$

$V_{DD}-V_{T4}+V\phi$